# EUROPEAN PATENT SPECIFICATION

(11) **EP 3 627 691 B1**
(45) Date of publication and mention of the grant of the patent: **04.05.2022**
(21) Application number: 18275144.6
(22) Date of filing: 18.09.2018
(51) Int. Cl.: H02P 21/14, H02P 23/14, H02P 29/024

(54) **USE OF MOTOR FLUX LINKAGE MAPS FOR MONITORING THE HEALTH OF AN ACTUATOR**
VERWENDUNG VON MOTORFLUSSVERKNÜPFUNGSKARTEN ZUR ÜBERWACHUNG DES ZUSTANDS EINES AKTUATORS
UTILISATION DE CARTOGRAPHIES DE FLUX DE FUITE D'UN MOTEUR DESTINÉES À SURVEILLER LA SANTÉ D'UN ACTIONNEUR

(43) Date of publication of application: 25.03.2020
(73) Proprietor: Goodrich Actuation Systems Limited, West Midlands B90 4SS (GB)
(72) Inventor: BENARUS, Maamar, Balsall Common, CV7 7DU (GB)
(74) Representative: Dehns

(56) References cited:
- EP-A1- 3 054 583
- DE-A1-102015 108 308
- US-A- 6 137 257

## Description

### FIELD

The present disclosure relates to a method and system for monitoring the health of an electric actuator.

### BACKGROUND

The examples described herein aim to provide an improved method for monitoring the health of an actuator.

US 10/003,287 B2 describes a system for diagnosing permanent magnet motor degradation and damage. The system comprises a permanent magnet motor, a motor drive and a controller. The controller is configured to determine a magnetic flux value using a calculation based upon motor voltage information and motor current information. The controller is also configured to evaluate an elevated temperature error condition of one or more of a plurality of permanent magnets based upon the magnetic flux value and a magnetic flux threshold.

US 9,985,564 B2 describes a system for estimating flux linkage in an electric motor. The system comprises a flux estimation module that generates estimated flux linkages based on a back electromagnetic force and estimated velocity of the electric motor. The flux linkage curves are then used to control the motor.

US 9,692,339 B2 describes a method and system for estimating differential inductances in an electric machine.

US 6,137,257 describes a method for monitoring the position of a switched reluctance motor having phase windings which are energized by a controller. A flux linkage associated with the active phase winding is established based at least in part on the current indicative signal and the voltage indicative signal. A position of the motor is then estimated based at least in part on the current indicative signal and the established flux linkage. EP 3054585 A1 describes a method and system for estimating differential inductances in an electric machine.

### SUMMARY

A method for monitoring the health of an actuator is described herein, the actuator comprising a permanent magnet motor, a rotor and a stator; the method for monitoring comprising: providing a flux linkage reference map comprising a) a nominal flux linkage map, having a plurality of nominal flux linkage curves of the motor, each of the nominal flux linkage curves being defined as defining a healthy condition of the actuator, and b) upper and lower tolerance limits of each of the nominal flux linkage curves, the range between the upper and lower limits being defined as a healthy condition of the actuator, and the method of monitoring the health of the actuator further comprising determining whether or not said actuator is healthy by generating a first flux linkage curve of the motor that is to be monitored and determining whether or not the generated first flux linkage curve to be monitored is between the defined upper and lower limits of the flux linkage reference map.

In some of the examples described herein, the flux linkage reference map may be generated by, when the actuator is known to be healthy, calculating a plurality of the nominal flux linkage curves of the motor, each of the nominal flux linkage curves corresponding to a different rotor position, and creating the nominal flux linkage map of the nominal flux linkage curves; and generating the flux linkage reference map by calculating tolerances on each of the nominal flux linkage curves of the nominal flux linkage map and, based on the tolerances, calculating the upper and lower limits of each nominal flux linkage curve between which the healthy condition of the actuator is defined, and adding the upper and lower limits into said nominal flux linkage map to create said flux linkage reference map.

In some of the examples described herein, the generated flux linkage curve to be monitored is calculated for the motor under load.

In some of the examples described herein, the generated flux linkage curve to be monitored is calculated for the motor under thermal conditions.

In some of the examples described herein, if the generated flux linkage curve to be monitored is determined as not being between the defined upper and lower limits of the reference flux linkage map for a given working condition, a warning is generated.

In some of the examples described herein, the tolerances may be calculated based on at least one condition.

In some of the examples described herein, the at least one condition may comprise a manufacturing tolerance or tolerances.

In some of the examples described herein, the at least one condition may comprise a material tolerance or tolerances of the actuator.

In some of the examples described herein, the at least one condition may comprise an environmental condition or conditions of the motor.

In some of the examples described herein, the plurality of nominal flux linkage curves may be calculated for different current levels at the different rotor positions.

In some of the examples described herein the defined upper and lower limits may provide a range outside of which a warning is raised.

In some of the examples described herein, the nominal and/or reference flux linkage maps may be loaded into motor drive/power drive electronics.

In some of the examples described herein, when the generated flux linkage curve to be monitored is within the defined upper and lower limits of the reference map for a given working condition, no warning is generated and the method step of generating a flux linkage curve to be monitored and determining whether or not the generated flux linkage curve is between the defined upper and lower limits of the flux linkage reference map is repeated.

A system configured to monitor the health of an actuator, as defined in independent claim 13. examples, the controller may be used for motor control and the method may be integrated into the same control chip or a different platform.

### BRIEF DESCRIPTION OF THE DRAWINGS

The subject matter of the present disclosure is particularly pointed out and distinctly claimed in the concluding portion of the specification. A more complete understanding of the present disclosure, however, may best be obtained by referring to the detailed description and claims when considered in connection with the figures, wherein like numerals denote like elements.
FIG. 1 illustrates an example of an electromechanical actuator which may be used with the methods described herein.
FIG. 2 illustrates an example of a flux linkage map that can be used in the examples described herein.
FIG. 3 illustrates an example of a new method of monitoring actuator health as described herein.

### DETAILED DESCRIPTION

The examples described herein relate to a method for monitoring the health of an electric actuator and a system that is configured to perform the method of monitoring the health of an electric actuator. In some examples, the method can be performed on an electrical actuator. This may be an electromechanical actuator or an electro-hydrostatic actuator. In the case wherein an electromechanical actuator is used, the system that is being monitored may consist of a motor driving a gear box and a screw (in the case of a geared actuator), or a motor driving directly a screw (in the case of a direct drive actuator). For an electro-hydrostatic actuator, a motor drives a hydraulic pump.

The methods described herein can be performed on a used component, or they can also be performed on a brand new component. The reference map must be created based on a component that is known to be healthy. Performing the method on a brand new component may be useful in the situation wherein there is a premature failure with a component, as this method would be able to detect that failure.

In the examples described herein, the actuator comprises an electric permanent magnet motor, comprising a permanent magnet, a rotor and a stator. The actuator also comprises other components, as is known in the art, such as a gear box, screw etc.

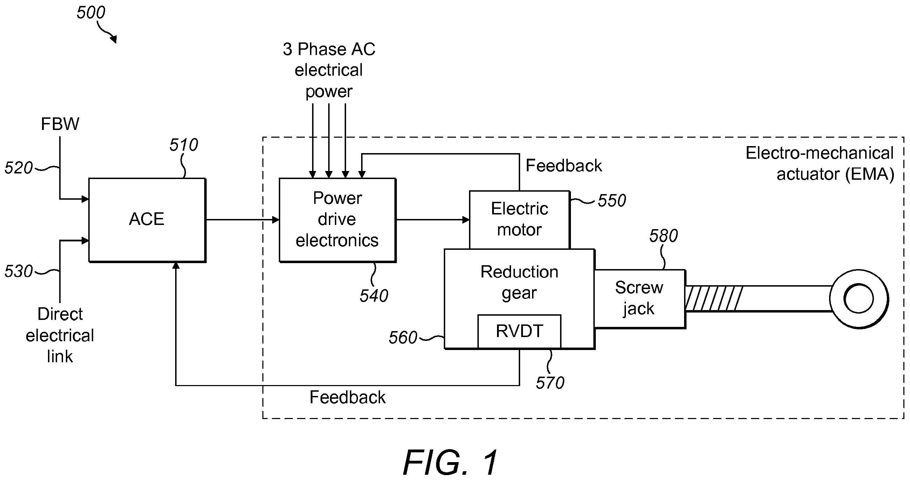

For reference, an example of an electromechanical actuator (EMA) 500 is depicted in figure 1. The EMA comprises actuator control electronics (ACE) 510 to which a Fly-By-Wire (FBW) 520 and direct electrical link 530 may be connected. The ACE 510 is in turn connected to power/motor drive electronics 540, which receives 3 phase AC electrical power. The power/motor drive electronics 540 are also connected to the electric motor which comprises a reduction gear 560 having a rotary variable differential transformer (RVDT) 570. The RVDT 570 and the electric motor provide feedback to ACE and power/motor drive electronics 540 respectively. A screw jack 580 is connected to the reduction gear. Although the example shown here in figure 1 relates to one example of an EMA 500, the methods described herein are not limited to this and other variations may be used. The methods may also be used with an electro hydrostatic actuator (EHA).

In the method described herein, flux linkage maps are generated from the motor and used to monitor the health of the actuator. A flux linkage map is specific and unique to each electrical motor. Due to this, they can be used to check and monitor the health of the actuator, since its flux linkage curves will be displaced when the actuator becomes unhealthy.

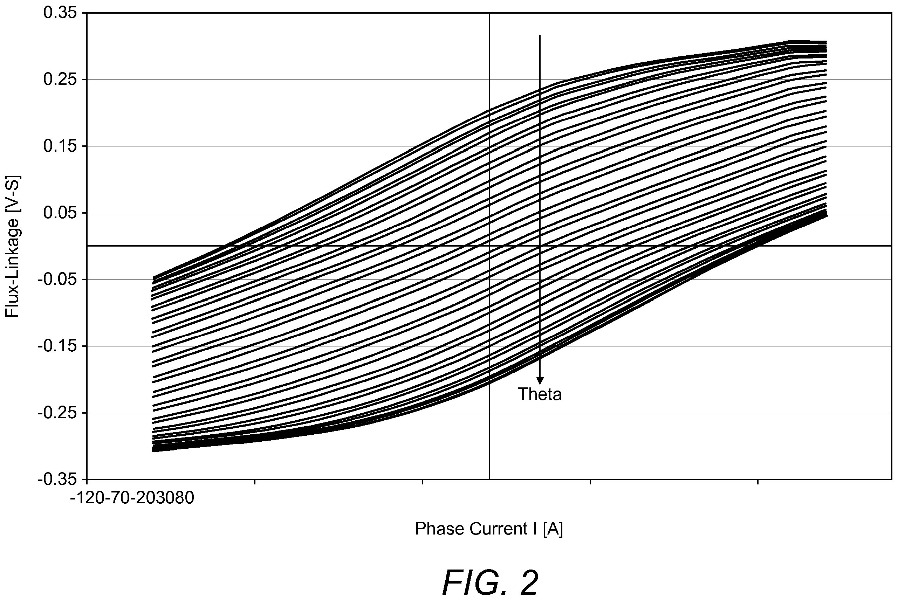

For example the graph or flux linkage map shown in figure 2 shows the flux linkage (V-S) versus motor phase current (A) for different rotor positions of the motor. It can be seen that, for a single curve, each point is identified as a flux linkage for a given current (load), and so a different flux linkage value may be expected for different current levels at the same motor rotor position. The movement of the rotor from one physical position to another will force a move from one curve to another one. Each curve of the map represents a rotor position between 0 degrees (i.e. the top curve in the map) and 360 degrees (i.e. bottom curve of the map) in steps of 9 degrees. The method and system described herein therefore generate the flux linkage curves for different current levels at all rotor positions. That is, each curve of the flux linkage map links what the flux linkage should be for a known positive and negative current level. These are then used (as described below) to monitor the health of the actuator.

Over time, it is expected that each of the curves shown in the graph of figure 2 changes a little due to material and manufacturing tolerances as well as environmental conditions. The examples described herein therefore take into consideration these factors and the map may be calculated for rated conditions. The changes will be due to wear and tear of the product components, but the curves calculated for rated condition will change due to environmental condition as well as manufacturing and material tolerances. The change or movement of the curves due to environmental changes, manufacturing and material tolerances will be evaluated and defined as an acceptable movement of the curves. Change over time due to wear and tear should drive the flux map curves to seat outside of the defined limits.

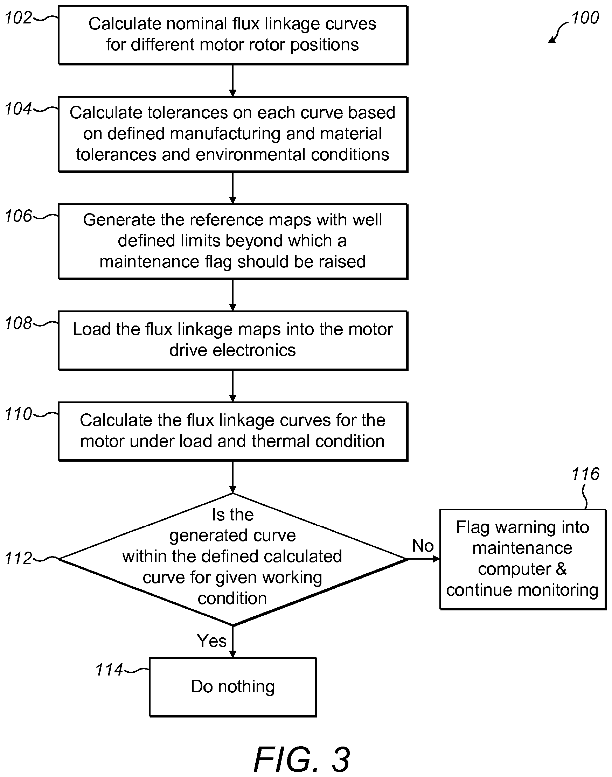

In some examples, the method and system may be configured to use a resolver and a sensor or sensors to perform the method described herein. The method 100 is a method of prognostic health monitoring of an actuator of an electric motor achieved via the following steps which are outlined in figure 3.

In summary, the steps of the method comprise the following: 1) define the curve which constitutes the map for the nominal condition and for different currents, 2) define the potential movement of the curve, i.e. define the possible tolerances that can be accepted for the curves based on mechanical manufacturing tolerances, material tolerances and the different environmental conditions, so that each point of the each curve will have a positive and a negative limit which should not be exceeded, 3) once these limits are defined, new points are generated on the curve, to which measurements will be compared using a look-up or reference table, 4) if a point is found to be within these limits then it means that the actuator is healthy and so nothing further needs to be done. If this is not the case, and the points are outside the healthy range then an alarm for maintenance may be raised. The method will now be described in greater detail.

When the actuator is known to be healthy 102, the method and system may be configured to measure the voltage at a given position or positions of the rotor and for given currents. The system is further configured to use this data to calculate a plurality of the nominal flux linkage curves for these different rotor positions, which are shown in a nominal flux linkage map in figure 2. That is, nominal flux linkage curves may be generated for different current levels for all rotor positions when the actuator is known to be healthy.

The system may be further configured to use this nominal flux linkage map as a basis upon which a reference flux linkage map may be created, this reference flux linkage map being the map which is later used as a reference to determine if the actuator is healthy or not.

The system and method therefore involves calculating tolerances on each curve of the nominal flux linkage map. These tolerances may be based on conditions such as defined manufacturing and material tolerances and environmental conditions 104. The tolerances may also be based on other conditions. These tolerances may then be used to calculate/generate upper and lower limits for each nominal flux linkage curve in the nominal flux linkage map. These upper and lower limits define a range within which the actuator is indicated as being in a healthy condition. These upper and lower limits are loaded into and combined with the nominal flux linkage reference map that has already been calculated under the nominal condition (as described above) to create the reference flux linkage map.

These new upper and lower limits of the reference map may be described as defining the lower and upper limits between which a healthy condition of the actuator can be defined and represented. Therefore, in order to monitor the health of the actuator, once the reference map has been created, a flux linkage curve that is generated from the motor can be compared against this reference map to determine if the actuator is still within the healthy condition range.

In some systems and methods, a warning can be given if the health is not within the determined healthy range. This is because, once these tolerances on the curves have been defined in the reference map, the boundaries beyond which a potential maintenance flag may be raised are well defined. As shown in figure 1, due to these upper and lower limits being defined in the reference flux linkage map, the reference map is able to provide well defined limits beyond which a maintenance flag should or may be raised 106.

In some examples, the motor drive may contain power/motor drive electronics and the system may be further configured to load the flux linkage map or maps into the power/motor drive electronics at step 108. That is, the power/motor drive electronics can be used as a means for implementing the methods for monitoring described herein.

At step 110, the health of the actuator is monitored by calculating the flux linkages for the motor under load and thermal conditions and comparing these to the reference map (and specifically the range between the upper and lower limits) to determine whether or not the actuator is healthy.

This comparison is made using a processor and logic, which calculate the actual flux linkage value. This should be compared to values that are calculated for exactly the same condition of current (load) and temperature that have been uploaded into the memory as a look-up table.

Since the load is directly linked to the current magnitude, under different loads and currents, different flux linkage values will be calculated. Therefore, in order to check whether the flux linkage value is within the expected value range, knowledge of the current is required. In addition to this, under different thermal conditions, the flux linkage value will also change slightly, again resulting in a different flux linkage value. In summary, in order to check the health of the actuator and to ensure that the flux linkage value is correct as expected or not, the current and temperature must be known.

The system and method therefore determines whether or not the generated curve is within the defined range for a given working condition 112.

If the system determines that, yes, the generated curve is within the defined range (or calculated curve) for a given working condition, the system does not do anything further 114 and the method may be repeated.

On the other hand, if the system determines that, no, the generated curve is not within the defined range (or calculated curve) for a given working condition, the system is configured to generate a flag warning into a maintenance computer 116. In some examples, this may instigate the continued monitoring of the motor health and the method 100 may then repeat itself.

In some examples, an existing current sensor and temperature sensor (that may already be used to control the motor) may be used to feed data into an algorithm that is used by the system to calculate flux linkage maps. The current sensor will give the information regarding current level and the temperature sensor will allow the definition of the environmental conditions. Both of these inputs will define the location of the reference point for comparison.

## Claims

1. A method (100) for monitoring the health of an actuator (500), said actuator (500) comprising a permanent magnet motor (550), a rotor and a stator; said method for monitoring comprising:
providing a flux linkage reference map comprising:
a) a nominal flux linkage map, having a plurality of nominal flux linkage curves of said motor, each of said nominal flux linkage curves defining a healthy condition of said actuator, and **characterized by** said flux link reference map further comprising
b) upper and lower tolerance limits of each of said nominal flux linkage curves, the range between said upper and lower limits being defined as a healthy condition of said actuator, and
said method of monitoring the health of the actuator (500) further comprising determining whether or not said actuator (500) is healthy, by:
c) generating a first flux linkage curve of said motor (550) that is to be monitored, and
d) determining whether or not said generated first flux linkage curve is between the defined upper and lower limits of said flux linkage reference map.

2. The method of claim 1 wherein said flux linkage reference map is generated when the actuator (500) is known to be healthy by calculating a plurality of said nominal flux linkage curves of said motor (550), each of said nominal flux linkage curves corresponding to a different rotor position, and creating said nominal flux linkage map of said nominal flux linkage curves (102); and
calculating tolerances on each of said nominal flux linkage curves and, based on said tolerances, calculating said upper and lower limits of each nominal flux linkage curve between which said healthy condition of the actuator is defined, and adding said upper and lower limits into said nominal flux linkage map to create said flux linkage reference map.

3. The method of claim 1 or 2 wherein said generated flux linkage curve is calculated for the motor under load.

4. The method of any preceding claim wherein said generated flux linkage curve is calculated for the motor under thermal conditions.

5. The method of any preceding claim wherein,
if said generated flux linkage curve is determined as not being between the defined upper and lower limits of said reference flux linkage map for a given working condition, a warning is generated (116).

6. The method of any preceding claim wherein said tolerances are calculated based on at least one condition.

7. The method of claim 6 wherein said at least one condition comprises a manufacturing tolerance or tolerances of said actuator.

8. The method of claim 6 or 7 wherein said at least one condition comprises a material tolerance or tolerances of the actuator (500).

9. The method of any of claims 6, 7 or 8 wherein said at least one condition comprises an environmental condition or conditions of the actuator (500).

10. The method of any preceding claim wherein said plurality of nominal flux linkage curves are calculated for different current levels at said different rotor positions.

11. The method of any preceding claim wherein said reference flux linkage map is loaded (108) into motor drive electronics (540).

12. The method of any preceding claim wherein, when said generated flux linkage curve is within the defined upper and lower limits of said flux linkage reference map for a given working condition based on load, position and environmental condition, no warning is generated and said method step of generating a flux linkage curve and determining whether or not said generated flux linkage curve is between the defined upper and lower limits of said flux linkage reference map is repeated at a later time.

13. A system configured to monitor the health of an actuator (500), said system comprising: said actuator (500) having a permanent magnet motor (550), a rotor and a stator, **characterized by** said system further comprising a controller configured to perform the method of any preceding claim.

14. The system of claim 13 wherein said controller is used for motor control and wherein said method is integrated into the same control chip or a different platform.

## Patentansprüche

1. Verfahren (100) zum Überwachen des Zustands eines Aktuators (500), wobei der Aktuator (500) einen Permanentmagnetmotor (550), einen Rotor und einen Stator, umfasst; wobei das Verfahren zum Überwachen Folgendes umfasst:
Bereitstellen einer Flussverkettungsreferenzkarte, die Folgendes umfasst:
a) eine Nennflussverkettungskarte, die eine Vielzahl von Nennflussverkettungskurven des Motors aufweist, wobei jede der Nennflussverkettungskurven einen gesunden Zustand des Aktuators definiert, und **dadurch gekennzeichnet, dass** die Flussverkettungsreferenzkarte ferner Folgendes umfasst:
b) eine obere und eine untere Toleranzgrenze jeder der Nennflussverkettungskurven, wobei der Bereich zwischen der oberen und der unteren Grenze als ein gesunder Zustand des Aktuators definiert ist, und
wobei das Verfahren zum Überwachen des Zustands des Aktuators (500) ferner das Ermitteln, ob der Aktuator (500) gesund ist oder nicht, durch Folgendes umfasst:
c) Erzeugen einer ersten Flussverkettungskurve des Motors (550), der zu überwachen ist, und
d) Ermitteln, ob die erzeugte erste Flussverkettungskurve zwischen der definierten oberen und unteren Grenze der Flussverkettungsreferenzkarte liegt.

2. Verfahren nach Anspruch 1, wobei, wenn bekannt ist, dass der Aktuator (500) gesund ist, die Flussverkettungsreferenzkarte erzeugt wird durch Berechnen einer Vielzahl der Nennflussverkettungskurven des Motors (550), wobei jede der Nennflussverkettungskurven einer anderen Rotorposition entspricht, und Erzeugen der Nennflussverkettungskarte der Nennflussverkettungskurven (102); und
Berechnen von Toleranzen an jeder der Nennflussverkettungskurven und, basierend auf den Toleranzen, Berechnen der oberen und unteren Grenze jeder Nennflussverkettungskurve, zwischen denen der gesunde Zustand des Aktuators definiert ist,
und Hinzufügen der oberen und unteren Grenze in die Nennflussverkettungskarte, um die Flussverkettungsreferenzkarte zu erschaffen.

3. Verfahren nach Anspruch 1 oder 2, wobei die erzeugte Flussverkettungskurve für den Motor unter Last berechnet wird.

4. Verfahren nach einem der vorstehenden Ansprüche, wobei die erzeugte Flussverkettungskurve für den Motor unter Wärmebedingungen berechnet wird.

5. Verfahren nach einem der vorstehenden Ansprüche, wobei, wenn die erzeugte Flussverkettungskurve als nicht zwischen der definierten oberen und unteren Grenze der Referenzflussverkettungskarte für eine gegebene Arbeitsbedingung ermittelt wird, eine Warnung erzeugt wird (116) .

6. Verfahren nach einem der vorstehenden Ansprüche, wobei die Toleranzen basierend auf mindestens einer Bedingung berechnet werden.

7. Verfahren nach Anspruch 6, wobei die mindestens eine Bedingung eine Herstellungstoleranz oder -toleranzen des Aktuators umfasst.

8. Verfahren nach Anspruch 6 oder 7, wobei die mindestens eine Bedingung eine Materialtoleranz oder -toleranzen des Aktuators (500) umfasst.

9. Verfahren nach einem der Ansprüche 6, 7 oder 8, wobei die mindestens eine Bedingung eine Umgebungsbedingung oder
- bedingungen des Aktuators (500) umfasst.

10. Verfahren nach einem der vorstehenden Ansprüche, wobei die Vielzahl von Nennflussverkettungskurven für verschiedene Strompegel an den verschiedenen Rotorpositionen berechnet werden.

11. Verfahren nach einem der vorstehenden Ansprüche, wobei die Referenzflussverkettungskarte in die Motorantriebselektronik (540) geladen wird (108).

12. Verfahren nach einem der vorstehenden Ansprüche, wobei, wenn die erzeugte Flussverkettungskarte innerhalb der definierten oberen und unteren Grenze der Flussverkettungsreferenzkarte für einen bestimmten Arbeitszustand basierend auf Last-, Positions- und Umweltbedingung liegt, keine Warnung erzeugt wird und der Verfahrensschritt des Erzeugens einer Flussverkettungskurve und Ermittelns, ob die erzeugte Flussverkettungskurve zwischen der definierten oberen und unteren Grenze der Flussverkettungsreferenzkarte liegt oder nicht, zu einem späteren Zeitpunkt wiederholt wird.

13. System, das konfiguriert ist, um den Zustand eines Aktuators (500) zu überwachen, wobei das System Folgendes umfasst: den Aktuator (500), der einen Permanentmagnetmotor (550), einen Rotor und einen Stator aufweist,
**dadurch gekennzeichnet, dass** das System ferner eine Steuerung umfasst, die so konfiguriert ist, dass sie das Verfahren nach einem der vorstehenden Ansprüche durchführt.

14. System nach Anspruch 13, wobei die Steuerung zur Motorsteuerung verwendet wird und wobei das Verfahren in demselben Steuerchip oder einer anderen Plattform integriert ist.

## Revendications

1. Procédé (100) pour surveiller l'état d'un actionneur (500), ledit actionneur (500) comprenant un moteur à aimant permanent (550), un rotor et un stator ; ledit procédé de surveillance comprenant :
la fourniture d'une carte de référence de liaison de flux comprenant :
a) une carte de liaison de flux nominal, ayant une pluralité de courbes de liaison de flux nominal dudit moteur, chacune desdites courbes de liaison de flux nominal définissant un bon état dudit actionneur, et **caractérisé par** ladite carte de référence de liaison de flux comprenant en outre
b) des limites de tolérance supérieure et inférieure de chacune desdites courbes de liaison de flux nominal, la plage entre lesdites limites supérieure et inférieure étant définie comme un bon état dudit actionneur, et
ledit procédé de surveillance de l'état de l'actionneur (500) comprenant en outre le fait de déterminer si ledit actionneur (500) est en bon état ou non, par :
c) la génération d'une première courbe de liaison de flux dudit moteur (550) qui doit être surveillée, et
d) le fait de déterminer si ladite première courbe de liaison de flux générée se situe ou non entre les limites supérieure et inférieure définies de ladite carte de référence de liaison de flux.

2. Procédé selon la revendication 1, dans lequel ladite carte de référence de liaison de flux est générée lorsque l'actionneur (500) est connu pour être en bon état par le calcul d'une pluralité desdites courbes de liaison de flux nominal dudit moteur (550), chacune desdites courbes de liaison de flux nominal correspondant à une position de rotor différente, et la création de ladite carte de liaison de flux nominal desdites courbes de liaison de flux nominal (102) ; et
le calcul de tolérances sur chacune desdites courbes de liaison de flux nominal et, sur la base desdites tolérances, le calcul desdites limites supérieure et inférieure de chaque courbe de liaison de flux nominal entre lesquelles ledit bon état de l'actionneur est défini, et l'ajout desdites limites supérieure et inférieure dans ladite carte de liaison de flux nominal pour créer ladite carte de référence de liaison de flux.

3. Procédé selon la revendication 1 ou 2, dans lequel ladite courbe de liaison de flux générée est calculée pour le moteur sous charge.

4. Procédé selon une quelconque revendication précédente, dans lequel ladite courbe de liaison de flux générée est calculée pour le moteur dans des conditions thermiques.

5. Procédé selon une quelconque revendication précédente dans lequel,
si ladite courbe de liaison de flux générée est déterminée comme ne se situant pas entre les limites supérieure et inférieure définies de ladite carte de liaison de flux de référence pour une condition de travail donnée, un avertissement est généré (116) .

6. Procédé selon une quelconque revendication précédente, dans lequel lesdites tolérances sont calculées sur la base d'au moins une condition.

7. Procédé selon la revendication 6, dans lequel ladite au moins une condition comprend une tolérance ou des tolérances de fabrication dudit actionneur.

8. Procédé selon la revendication 6 ou 7, dans lequel ladite au moins une condition comprend une tolérance ou des tolérances de matériau de l'actionneur (500).

9. Procédé selon l'une quelconque des revendications 6, 7 ou 8, dans lequel ladite au moins une condition comprend une condition ou des conditions environnementales de l'actionneur (500) .

10. Procédé selon une quelconque revendication précédente, dans lequel ladite pluralité de courbes de liaison de flux nominal sont calculées pour différents niveaux de courant au niveau desdites différentes positions de rotor.

11. Procédé selon une quelconque revendication précédente, dans lequel ladite carte de liaison de flux de référence est chargée (108) dans l'électronique de commande de moteur (540).

12. Procédé selon une quelconque revendication précédente, dans lequel, lorsque ladite courbe de liaison de flux générée se situe dans les limites supérieure et inférieure définies de ladite carte de référence de liaison de flux pour une condition de travail donnée sur la base de la charge, de la position et de la condition environnementale, aucun avertissement n'est généré et ladite étape de procédé de génération d'une courbe de liaison de flux et consistant à déterminer si ladite courbe de liaison de flux générée se situe ou non entre les limites supérieure et inférieure définies de ladite carte de référence de liaison de flux est répétée ultérieurement.

13. Système configuré pour surveiller l'état d'un actionneur (500), ledit système comprenant : ledit actionneur (500) ayant un moteur à aimant permanent (550), un rotor et un stator, **caractérisé par** ledit système comprenant en outre un dispositif de commande configuré pour mettre en œuvre le procédé selon une quelconque revendication précédente.

14. Système selon la revendication 13, dans lequel ledit dispositif de commande est utilisé pour la commande de moteur et dans lequel ledit procédé est intégré dans la même puce de commande ou une plate-forme différente.
